Europäisches Patentamt

European Patent Office

Office européen des brevets

(19)

(11) Veröffentlichungsnummer: **0 209 072 B1**

(12) **EUROPÄISCHE PATENTSCHRIFT**

(45) Veröffentlichungstag der Patentschrift: **22.01.92**

(51) Int. Cl.⁵: **B60R 16/02**, H05K 7/02

(21) Anmeldenummer: **86109367.2**

(22) Anmeldetag: **09.07.86**

(54) **Einrichtung für ein Kraftfahrzeug.**

(30) Priorität: **13.07.85 DE 3525085**

(43) Veröffentlichungstag der Anmeldung:
**21.01.87 Patentblatt 87/04**

(45) Bekanntmachung des Hinweises auf die
Patenterteilung:
**22.01.92 Patentblatt 92/04**

(84) Benannte Vertragsstaaten:
**DE FR GB IT**

(56) Entgegenhaltungen:
**EP-A- 0 130 844**  **EP-A- 0 142 053**
**FR-A- 2 357 147**  **GB-A- 1 150 611**
**US-A- 2 907 926**  **US-A- 2 995 686**
**US-A- 3 234 433**  **US-A- 3 715 629**
**US-A- 4 513 064**

(73) Patentinhaber: **Stribel GmbH**
**Benzstrasse**
**W-7443 Frickenhausen(DE)**

(72) Erfinder: **Stribel, Hans Peter**
**Ob der Luthereiche 26**
**W-7440 Nürtingen(DE)**

Rank Xerox (UK) Business Services

**Beschreibung**

Die Erfindung betrifft eine Einrichtung für ein Kraftfahrzeug mit den Merkmalen des Oberbegriffs des Anspruchs 1.

Eine aus der DE-A-3048451 als Zentralelektrik bekannte Einrichtung dieser Art weist in einem Isoliergehäuse ein Leiterpaket auf, das aus in verschiedenen Ebenen übereinander angeordneten, vorzugsweise plattenförmig ausgestanzten Flachleitern und dazwischen angeordneten Isolierplatten besteht.

Die Zentralelektrik erfüllt im wesentlichen eine Verteilerfunktion, um die elektrischen Verbraucher des Kraftfahrzeugs, wie z.B. Lampen, Scheibenwischer, Blinker und dergleichen, über Leiterstränge bzw. Kabelbäume mit elektrischer Spannung zu versorgen, die Funktionstüchtigkeit der Verbraucher zu überwachen und etwaige Fehler zu ermitteln und anzuzeigen. Die Ansteuerung der elektrischen Verbraucher erfolgt dabei über Schaltgeräte, die auf der Oberseite der Zentralelektrik, ebenso wie die Sicherungen der Verbraucherstromkreise, steckbar angeordnet sind, wobei Steckerstifte in Steckerbuchsen eingreifen, die an Endbereichen der Flachleiter in Richtung zur Oberseite hin ausgebildet sind. Die Kabelbäume sind dabei an der Unterseite der Zentralelektrik über Steckverbinder kontaktiert. Die aufgesteckten Schaltgeräte beinhalten zumeist eine elektronische Steuerschaltung, über die die jeweilige Ansteuerung des zugehörigen elektrischen Verbrauchers erfolgt. Der eigentliche Schaltvorgang für das Ein- und Ausschalten des Verbrauchers wird über ein im Schaltgerät vorgesehenes Relais vorgenommen. Da die verschiedenen Verbraucher unterschiedliche elektronische Ansteuerungen benötigen, ist in jedem einzelnen Schaltgerät eine entsprechende elektronische Steuerung vorzusehen, was verhältnismäßig aufwendig ist, da jedes einzelne Schaltgerät zudem durch zusätzliche bauelementaufwendige Schaltungsmaßnahmen gegen im Bordnetz des Kraftfahrzeugs auftretende negative Impulse, wie Spannungsspitzen und dergleichen, zu schützen ist. Wird ein Schaltgerät im Falle eines defekten Relais ausgetauscht, muß zwangsläufig auch die Elektroniksteuerung mit verworfen bzw. erneuert werden.

Aufgrund der konstruktiv fertigungstechnischen Flachleiter- und Steckerbuchsenauslegung ist die Zentralelektrik hinsichtlich ihrer Verteilerfunktion starr festgelegt und nur durch einen überdurchschnittlich großen Aufwand auf verschiedene unterschiedliche Anforderungen einstellbar bzw. anpassbar.

Anders verlaufende Flachleiterführungen sind nur durch besonders kostenintensive Werkzeugänderungen realisierbar, was insbesondere bei kleinen Serien in den meisten Fällen wirtschaftlich nicht vertretbar ist.

Die Aufgabe der Erfindung besteht darin, eine Einrichtung mit den Merkmalen des Oberbegriffs des Anspruchs 1 dahingehend weiterzubilden, daß entsprechend den jeweiligen Erfordernissen wahlweise verschiedene Flachleiterstromkreise mit einfachen Mitteln schaltungsmäßig individuell festgelegt werden können.

Diese Aufgabe wird erfindungsgemäß durch die kennzeichnenden Merkmale des Anspruchs 1 gelöst.

Bevorzugte Ausgestaltungen und Weiterbildungen sowie weitere Vorteile und wesentliche Einzelheiten der Erfindung sind den Merkmalen der Unteransprüche, der nachfolgenden Beschreibung und der Zeichnung zu entnehmen, die schematischer Darstellung bevorzugte Ausführungsformen als Beispiel zeigt. Es stellen dar:

FIG. 1    eine Sprengbilddarstellung einer erfindungsgemäßen Zentralelektrik und

FIG. 2    eine erfindungsgemäße Zentralelektrik ähnlich der FIG. 1, jedoch mit einem anders ausgeführten Isoliergehäuse.

Die in der Zeichnung dargestellte Zentralelektrik 1 ist für den Einbau in ein Kraftfahrzeug vorgesehen und so ausgeführt, daß hier eine Vielzahl von elektrischen Steuerleitungen und Stromkreisen für Verbraucher, wie Lampen, Scheibenwischer, Blinker, Heckscheibenheizung, Sitzheizung, Spiegelheizung, Magnetventile und dergleichen, mittels Steckverbindungen zentral zusammengefaßt werden können.

Die Zentralelektrik 1 weist ein Gehäuse 2 auf, das aus elektrisch isolierendem Kunststoff besteht und eine Bodenplatte 3 sowie eine mit der Bodenplatte 3 dicht abschließende Haube 4 umfassen kann. An der Unterseite der Bodenplatte 3 ragen Stecker 5 heraus, an denen die mit Steckverbindern versehenen elektrischen Leiterstränge und Kabelbäume angeschlossen werden können. An der Oberseite 6 des Gehäuses 2 sind Schlitzausnehmungen 7 ausgebildet, unter denen sich Steckerbuchsen 8 befinden. Auf der Oberseite 6 sind aufgesteckte Bauteile, wie elektrische Sicherungen 9 und ein Relais enthaltende Schaltgeräte 10, angeordnet, die mit ihren Steckerteilen 11 durch die Schlitzausnehmungen 7 hindurch in die Steckerbuchsen 8 eingreifen.

Im Gehäuse 2 befinden sich elektrische Flachleiter 12, die bevorzugt aus Metallblechen hergestellt und entsprechend ausgestanzt und gebogen sind. Die Flachleiter 12 sind in mehreren Ebenen übereinander geschichtet und gegeneinander durch plattenförmige Zwischenisolationen 13 elektrisch isoliert, so daß insgesamt ein plattenartig geschichtetes Leiterpaket 14 gebildet ist.

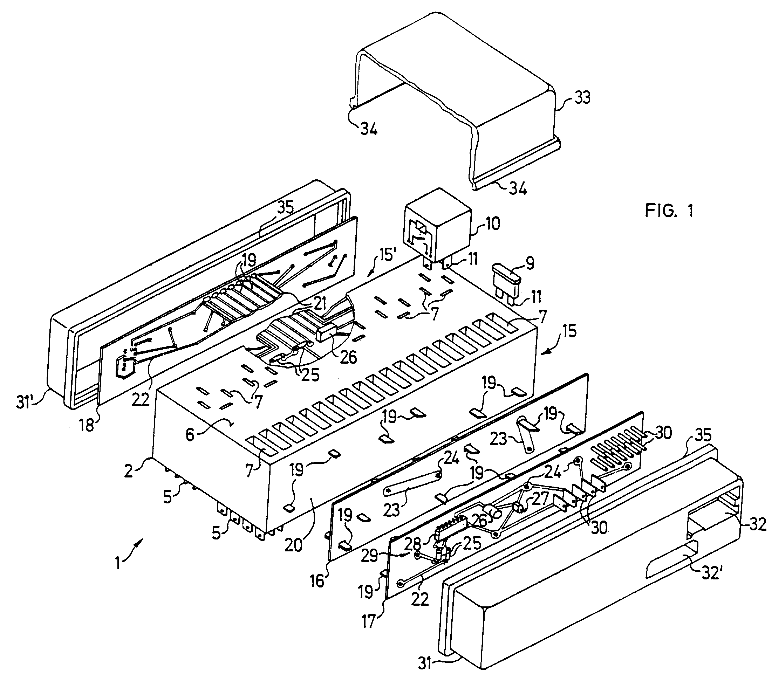

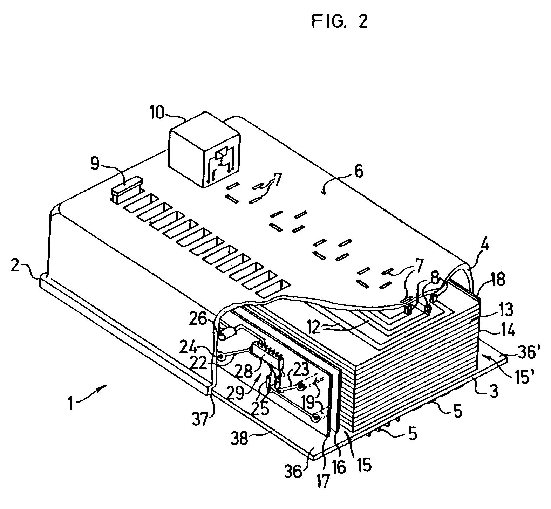

Der Zeichnung ist zu entnehmen, daß an der einen Längsseite 15 des Leiterpaketes 14 auf Abstand zueinander zwei Leiterplatten 16,17 angeordnet sind, während auf der gegenüberliegenden Längsseite 15' des Leiterpaketes 14 auf Abstand eine dritte Leiterplatte 18 sich befindet. Die Leiterplatten 16,17,18 sind so ausgerichtet, daß ihre Ebene quer zur Ebene der Flachleiter 12 und Zwischenisolationen 13 verläuft. Weiterhin ist zu erkennen, daß an den beiden Längsseiten 15,15' des Leiterpaketes 14 flachrechteckförmige Leiterteile 19 herausragen. Diese Leiterteile 19 befinden sich in verschiedenen Ebenen und erstrecken sich parallel zu den Ebenen der Flachleiter 12. Einige der Leiterteile 19 sind von den Flachleitern 12 abgezweigt, während die anderen Leiterteile 19 von den Steckerbuchsen 8 nach den Seiten hin weggeführt sind. Beim Ausführungsbeispiel der FIG. 1 durchsetzen die seitlich abstrebenden Leiterteile 19 die z.B. als Einzelplatten ausgeführten längsseitigen Wandungen 20 des Gehäuses 2 in Richtung zu den Leiterplatten 16,17,18 hin, während beim Ausführungsbeispiel der FIG.2 die Leiterteile 19 unmittelbar vom Leiterpaket 14 zu den Leiterplatten 16,17,18 hin sich erstrecken.

Die Leiterteile 19 können materialeinheitlich einstückig mit den Flachleitern 12 bzw. den Steckerbuchsen 8 ausgeführt sein oder als separater Leitersteg am Flachleiter 12 bzw. an der Steckerbuchse 8 z.B. durch Vernietung befestigt sein. Es kann jedoch bei verschiedenen Anwendungen auch günstig sein, die von den Flachleitern 12 und Steckerbuchsen 8 seitlich abstrebenden Leiterteile 19 auf einer elektrisch isolierenden Trägerplatte 21 anzuordnen, wobei die Leiterteile 19 z.B. als auf die Trägerplatte 21 aufkaschierte oder auch herausgeätzte Metallfolienleiter ausgeführt sein können. Die in der FIG. 1 dargestellte Trägerplatte 21 mit den z.B. aufkaschierten Leiterteilen 19 erstreckt sich parallel zur Ebene der Flachleiter 12 in Richtung zur Leiterplatte 18, an der die Leiterteile 19 mit den Leiterbahnen 22 der Leiterplatte 18 elektrisch verbunden sind. Die Verbindung kann bevorzugt als Lötverbindung ausgeführt sein, jedoch kann es auch günstig sein, die elektrische Kontaktierung der Leiterteile 19 mit den Leiterbahnen 22 als Steckverbindung mit federnden Kontaktzungen bzw. Federbuchsen auzuführen. Darüber hinaus können die seitlich abstrebenden Leiterteile 19 wahlweise über Leiterbrücken 23 miteinander verbunden sein, die vorteilhaft an den Leiterplatten 16,17,18 angeordnet bzw. ausgebildet sein können. Durch die wahlweise Verbindung über die Leiterbrücken 23 ist der Vorteil gegeben, daß aufwendige Werkzeugänderungen für anders ausgeführte Flachleiter 12 nicht erforderlich sind, um eine individuelle Anpassung an die verschiedenen Anforderungen zur Erzielung unterschiedlich geschalteter Verbraucherstromkreise zu erreichen, so daß insbesondere werkseitig die verschiedensten Stromkreise entsprechend den Erfordernissen allein durch eine einfache Verlagerung der Leiterbrücken 23 geschaltet werden können.

Insbesondere der FIG. 1 ist zu entnehmen, daß einige der seitlich vom Leiterpaket 14 abstrebenden Leiterteile 19 die erste Leiterplatte 16 durchsetzen und an der zweiten parallelen Leiterplatte 17 kontaktiert sind. Die zur zweiten Leiterplatte 17 geführten Leiterteile 19 können durch die erste Leiterplatte 16 ohne irgend eine elektrische Kontaktierung hindurchgeführt sein, sie können aber auch mit einer Leiterbahn 22, wie sie an der zweiten Leiterplatte 17 ausgebildet ist, oder mit der Leiterbrücke 23 verbunden bzw. verlötet sein. Die Leiterteile 19 können an ihren freien Enden vorteilhaft Zapfen 24 besitzen, die mit den Leiterbahnen 22 bzw. mit den Leiterbrücken 23 bevorzugt verlötet sind.

Außerdem ist den FIG. 1 und 2 zu entnehmen, daß mindestens an der einen seitlichen Leiterplatte 17 elektronische Bauteile, wie z.B. Widerstand 25, Kondensator 26, Transistor 27, Mikroprozessor 28 und dergleichen, vorgesehen sein können. Dabei ist es besonders günstig, die elektronischen Bauteile 25 bis 28 unter Einbeziehung der Leiterbahnen 22 schaltungsmäßig so zu vereinen, daß solche elektronischen Steuerschaltungen erzielt werden, wie sie bisher in den bekannten aufsteckbaren Schaltgeräten zur Ansteuerung, Überwachung und Regelung der elektrischen Verbraucher des Kraftfahrzeugs verwirklicht wurden. Bei der vorgeschlagenen Zentralelektrik 1 sind somit die elektronischen Steuerungen für die elektrischen Verbraucher getrennt von den oben in die Steckerbuchsen 8 einsteckbaren Schaltgeräten 10 ausgeführt und an mindestens einer der seitlichen Leiterplatten 16, 17, 18 realisiert. Die an der Leiterplatte 17 positionierten elektronischen Steuerungen für die elektrischen Verbraucher sind schaltungsmäßig über die mit den seitlich abstrebenden Leiterteilen 19 verbundenen Steckerbuchsen 8 und Flachleiter 12 mit den elektrischen Verbrauchern bzw. Verbraucherstromkreisen gekoppelt. Durch diese Ausbildung wird der besondere Vorteil erreicht, daß die elektronischen Steuerungen für die elektrischen Verbraucher mit einfachen Mitteln kostengünstig an den Leiterplatten 16,17,18 hergestellt werden können. Die aufsteckbaren Schaltgeräte 10 können dadurch ebenfalls wesentlich einfacher und kostengünstiger hergestellt werden, da weitgehend gleichbleibende Serienausführungen z.B. nur mit einer Relaisbestückung praktiziert werden können. Sollte es einmal notwendig sein, ein Schaltgerät 10 auszutauschen, so ist auch diese Maßnahme wesentlich günstiger als bisher ausführbar, da die elektronische Steuerung an der Zentralelektrik 1 verbleibt und nur das Schaltgerät 10 mit dem Relais auszuwechseln ist.

Ein weiterer wesentlicher Vorteil ist bei der vorgeschlagenen Zentralelektrik 1 dadurch zu erreichen, daß die an der Seite des Leiterpaketes 14 an mindestens einer der Leiterplatten 16,17,18 angeordneten elektronischen Steuerungen für die verschiedenen elektrischen Verbraucher des Kraftfahrzeugs in einem Mikrocomputer 29 zentral zusammengefaßt sind. Der Mikrocomputer 29 weist dazu mindestens den als elektronischen Rechner ausgebildeten Mikroprozessor 28 mit mindestens einem Programmspeicher sowie mindestens eine Ein- und Ausgabeeinheit und zugehörige Peripheriegeräte (elektronische Bauteile) auf. Dadurch wird eine kompakte und kostengünstige Zusammenfassung mehrerer verschiedener Elektroniksteuerungen zur Ansteuerung der verschiedenen elektrischen Verbraucher des Kraftfahrzeugs erzielt. Die zentrale Zusammenfassung der unterschiedlichen elektronischen Steuerungen im Mikrocomputer 29 ist dabei ebenfalls unabhängig von den nur mit einem Relais zu bestückenden Schaltgeräten 10 ausgeführt und beinhaltet außerdem die vorteilhafte Möglichkeit, eine erhebliche Erweiterung der verschiedensten Steuerfunktionen auf kleinstem Raum durchzuführen. Zudem wird durch die Zusammenfassung im Mikrocomputer 29 der Vorteil einer erhöhten Funktionssicherheit erzielt, da gegenüber den bisherigen einzelnen elektronischen Ansteuerungen in den aufsteckbaren Schaltgeräten wesentlich weniger Bauelemente erforderlich sind. Ein weiterer Vorteil besteht darin, daß für die Mikrocomputer-Steuerelektronik 29 der Zentralelektrik 1 nur noch eine einzige Absicherung gegen Spannungsspitzen, Überspannungen und negative Impulse des Bordnetzes notwendig ist.

Die FIG. 1 zeigt, daß an der seitlich neben dem Leiterpaket 14 vorgesehenen zweiten Leiterplatte 17 bevorzugt in Gruppen zusammengefaßte Kontaktstecker 30 angeordnet sein können. Die Kontaktstecker 30 können als im Querschnitt flachrechteckförmige oder auch kreisringförmige Stifte ausgeführt sein, die seitlich aus der Zentralelektrik 1 herausgeführt sind und auf die an Kabelsträngen befindliche Mehrfachstecker aufgesteckt werden können.

Beim Ausführungsbeispiel der FIG. 1 sind zwei Seitenhauben 31,31' vorgesehen, die die Leiterplatten 16,17,18 überdecken und an den seitlichen Wandungen 20 des Gehäuses 2 anliegen. In der Seitenhaube 31 sind zwei Ausnehmungen 32,32' ausgebildet, in die unterschiedlich gestaltete Mehrfachstecker von Kabelsträngen eingesetzt werden können. In die Ausnehmung 32 ragen die im Querschnitt kreisringförmig ausgeführten Kontaktstecker 30 hinein, während die im Querschnitt flachrechteckförmigen Kontaktstecker 30 in die Ausnehmung 32' der Seitenhaube 31 hineingeführt sind. Auf der Oberseite 6 des Gehäuses 2 kann zudem eine Dachhaube 33 vorgesehen sein, welche die Sicherungen 9 und Schaltgeräte 10 überdeckt. Die Dachhaube 33 liegt dabei zweckmäßig mit einem Umfangsrand 34 auf dem Gehäuse 2 dicht auf und kann zudem an Randteile 35 der Seitenhauben 31,31' dicht angrenzen, so daß insgesamt eine weitgehend dichte Gehäuseabkapselung erreicht werden kann. Es ist jedoch zu erwähnen, daß die Dachhaube 33 bei den überwiegend vorkommenden Anwendungsfällen nicht erforderlich ist, da die Zentralelektrik 1 auch ohne diese Dachhaube 33 für eine optimale Dauerfunktion durch das Gehäuse 2 und die Seitenhauben 31,31' gegen äußere Einwirkungen zuverlässig geschützt ist.

Der FIG. 2 ist zu entnehmen, daß bei diesem Ausführungsbeispiel die Bodenplatte 3 des Gehäuses 2 verbreitert ausgeführt ist, so daß an beiden Längsseiten 15,15' des Leiterpaketes 14 überstehende Bodenteile 36,36' gegeben sind. Die seitlichen Leiterplatten 16,17,18 sind in den Bereichen der überstehenden Bodenteile 36,36' angeordnet. Die Haube 4 ist entsprechend größer ausgebildet, und zwar so, daß ihre untere Umfangskante 37 am äußeren Rand 38 der verbreiterten Bodenplatte 3 dicht anliegt. Bei diesem Ausführungsbeispiel sind demnach keine separaten Seitenhauben erforderlich, da die Haube 4 des Gehäuses 2 sowohl das Leiterpaket 14 als auch die Leiterplatten 16,17,18 mit den vorbeschriebenen Teilen im Bereich der verbreiterten Bodenplatte 3 insgesamt überdeckt.

Schließlich sei noch erwähnt, daß es bei der vorgeschlagenen Zentralelektrik 1 mit an mindestens einer der Leiterplatten 16,17,18 angeordneten elektronischen Steuerungen für die elektrischen Verbraucher besonders günstig sein kann, in dem oben in die Steckerbuchsen einzusteckenden Schaltgerät 10 statt eines elektromagnetischen Relais einen vorzugsweise auf einer Halbleiterbasis beruhenden elektronischen Schalter vorzusehen. Dieser elektronische Schalter kann zweckmäßig als Schalttransistor ausgeführt und bevorzugt als Leistungstransistor für hohe Schaltströme ausgelegt sein. Durch den Einbau des elektronischen Schalters kann eine noch einfachere und kostengünstigere Herstellung des Schaltgerätes 10 und eine verbesserte Dauerfunktionstüchtigkeit mit erhöhter Schalthäufigkeit erreicht werden.

**Patentansprüche**

1. Einrichtung für ein Kraftfahrzeug zum zentralen Anschluß elektrischer Bauteile, wie Sicherungen (9), Steckerverbinder, Kabelbäume, elektronische Steuerungen für elektrische Verbraucher, Schaltgeräte (10), mit einem plattenartig geschichteten Leiterpaket (14), das in verschiedenen Ebenen übereinander angeordnete Flachleiter (12) aufweist, die durch Zwischenisolationen (13) voneinander getrennt sind und denen Steckerbuchsen (8) zur Aufnahme von an den Bauteilen befindlichen Steckerteilen (11) zugehörig sind, dadurch gekennzeichnet, daß an mindestens einer der Steckerbuchsen (8) mindestens ein das Leiterpaket (14) an mindestens einer Seite (15,15') überragender Leiterteil (19) angeordnet ist, der mit mindestens einem weiteren an mindestens einer Seite (15,15') des Leiterpaketes (14) herausragenden und an mindestens einem der isoliert übereinander liegenden Flachleiter (12) angeordneten Leiterteil (19) über eine Leiterbrücke (23) an der Seite (15,15') des Leiterpaketes (14) wahlweise verbindbar ist.

2. Einrichtung nach vorstehendem Anspruch, dadurch gekennzeichnet, daß an der Seite (15,15') des Leiterpaketes (14) mindestens eine den herausgeführten Leiterteilen (19) der Steckerbuchse (8) und des Flachleiters (12) zugeordnete Leiterplatte (16,17,18) quer zur Ebene der Flachleiter (12) und Zwischenisolationen (13) angeordnet ist.

3. Einrichtung nach einem der vorstehenden Ansprüche, dadurch gekennzeichnet, daß die Leiterbrücke (23) an der Leiterplatte (16,17,18) angeordnet und an dieser mit den von der Steckerbuchse (8) und dem Flachleiter (12) seitlich herausgeführten Leiterteilen (19) kontaktiert ist.

4. Einrichtung nach einem der vorstehenden Ansprüche, dadurch gekennzeichnet, daß mindestens einer der vom Leiterpaket (14) seitlich abstrebenden Leiterteile (19) die Leiterplatte (16) durchsetzt und an einer zweiten Leiterplatte (17) kontaktiert ist, die parallel neben der ersten Leiterplatte (16) angeordnet ist.

5. Einrichtung nach einem der vorstehenden Ansprüche, dadurch gekennzeichnet, daß die seitlich vom Leiterpaket (14) abstrebenden Leiterteile (19) selbst oder ein an diesen ausgebildeter Zapfen (24) mit Leiterbahnen (22) und/oder mit der Leiterbrücke (23) der Leiterplatte (16,17,18) elektrisch verbunden sind.

6. Einrichtung nach einem der vorstehenden Ansprüche, dadurch gekennzeichnet, daß auf der seitlichen Leiterplatte (16,17,18) Bauteile, wie Widerstand (25), Kondensator (26), Transistor (27), Mikroprozessor (28), der elektronischen Steuerungen für die verschiedenen elektrischen Verbraucher des Kraftfahrzeugs getrennt von den in die Steckerbuchsen (8) einsteckbaren Schaltgeräten (10) angeordnet und über die Leiterbahnen (22) mit den seitlich vom Leiterpaket (14) abstrebenden Leiterteilen (19) verbunden sind.

7. Einrichtung nach einem der vorstehenden Ansprüche, dadurch gekennzeichnet, daß die elektronischen Steuerungen für die verschiedenen elektrischen Verbraucher des Kraftfahrzeugs auf der an der Seite (15,15') des Leiterpaketes (14) positionierten Leiterplatte (16,17,18) in einem Mikrocomputer (29) zentral zusammengefaßt sind, der mindestens einen als elektronischen Rechner ausgebildeten Mikroprozessor (28) mit mindestens einem Programmspeicher sowie mindestens eine Ein- und Ausgabeeinheit und zugehörige Peripheriegeräte aufweist.

8. Einrichtung nach einem der vorstehenden Ansprüche, dadurch gekennzeichnet, daß an der seitlich neben dem Leiterpaket (14) vorgesehenen Leiterplatte (17) etwa in Verlängerung der seitlich abstrebenden Leiterteile (19) Kontaktstecker (30) zum Anschluß von Kabelsträngen angeordnet und seitlich herausgeführt sind.

9. Einrichtung nach einem der vorstehenden Ansprüche, dadurch gekennzeichnet, daß die mit den Steckerbuchsen (8) und Flachleitern (12) über die seitlich abstrebenden Leiterteile (19) verbundenen Leiterplatten (16,17,18) an zwei gegenüberliegenden parallelen Seiten (15,15') des Leiterpaketes (14) vorgesehen sind.

10. Einrichtung nach einem der vorstehenden Ansprüche, dadurch gekennzeichnet, daß die seitlich vom Leiterpaket (14) abstrebenden Leiterteile (19) der Flachleiter (12) und Steckerbuchsen (8) auf einer elektrisch isolierenden Trägerplatte (21) angeordnet sind, die parallel zur Ebene der Flachleiter (12) an der Seite (15,15') des Leiterpaketes (14) vorsteht und etwa rechtwinklig an die Leiterplatte (18) angrenzt.

11. Einrichtung nach einem der vorstehenden Ansprüche, dadurch gekennzeichnet, daß die seitliche Leiterplatte (16,17,18) im Bereich eines überstehenden Bodenteils (36,36') einer das Leiterpaket (14) und die Leiteplatte (16,17,18) gemeinsam untergreifenden Bodenplatte (3) eines Gehäuses (2) angeordnet ist und von einer an den Rändern (38) der Bodenplatte (3) festgelegten Haube (4) des Gehäuses (2) mit überdeckt ist.

12. Einrichtung nach einem der vorstehenden Ansprüche, dadurch gekennzeichnet, daß die von den Steckerbuchsen (8) und den Flachleitern (12) abstrebenden Leiterteile (19) eine seitliche Wandung (20) des das Leiterpaket (14) umschließenden Gehäuses (2) durchsetzen, daß die Leiterplatte (16,17, 18) außen neben der Wandung (20) des Gehäuses (2) vorgesehen ist und daß eine die Leiterplatte (16,17,18) übergreifende Seitenhaube (31,31') an der Wandung (20) des Gehäuses (2) anliegt.

13. Einrichtung nach einem der vorstehenden Ansprüche, dadurch gekennzeichnet, daß an den gegenüberliegenden Längsseiten (15,15')des Gehäuses (2) je eine an den Wandungen (20) anliegende Seitenhaube (31,31') vorgesehen ist.

14. Einrichtung nach einem der vorstehenden Ansprüche, dadurch gekennzeichnet, daß in der die Leiterplatte (16,17) überdeckenden Seitenhaube (31) mindestens eine Ausnehmung (32,32') für einen Mehrfachstecker ausgebildet ist, in die die Kontaktstecker (30) der Leiterplatte (17) hineinragen.

15. Einrichtung nach einem der vorstehenden Ansprüche, dadurch gekennzeichnet, daß die auf der Oberseite (6) des Gehäuses (2) in die Steckerbuchsen (8) eingesteckten Schaltgeräte (10) und Sicherungen (9) von einer Dachhaube (33) überdeckt sind, die mit einem Umfangsrand (34) auf dem Gehäuse (2) aufsitzt und bevorzugt an einen Randteil (35) der Seitenhaube (31,31') dicht angrenzt.

16. Einrichtung nach einem der vorstehenden Ansprüche, dadurch gekennzeichnet, daß bei auf der seitlichen Leiterplatte (16,17,18) angeordneter elektronischer Steuerung für die elektrischen Verbraucher im aufsteckbaren Schaltgerät (10) ein bevorzugt als Schalttransistor ausgeführter elektronischer Schalter vorgesehen ist.

## Claims

1. Device for a motor vehicle for the central connection of electrical components, such as fuses (9), plug connectors, wiring harnesses, electronic controls for electrical consuming units, switching devices (10), comprising a conductor package (14) layered in the manner of plates, which possesses in various levels flat conductors (12) disposed one above another, which are separated from each other by intermediate insulation (13) and with which are associated plug sockets (8) for receiving plug components (11) situated on the electrical components, characterized in that, on at least one of the plug sockets (8), at least one conductor part (19) projecting beyond the conductor package (14) on at least one side (15, 15') is disposed, which (conductor part) can be connected as desired, via a conductor bridge (23) at the side (15, 15') of the conductor package (14), with at least one further conductor part (19) projecting from at least one side (15, 15') of the conductor package (14) and disposed on at least one of the flat conductors (12) lying insulated one above another.

2. Device according to the preceding Claim, characterized in that, at the side (15, 15') of the conductor package (14), at least one printed circuit board (16, 17, 18), associated with the leading-out conductor parts (19) of the plug socket (8) and of the flat conductor (12), is disposed transversely to the plane of the flat conductors (12) and intermediate insulation layers (13).

3. Device according to one of the preceding Claims, characterized in that the conductor bridge (23) is disposed on the printed circuit board (16, 17, 18) and is contacted on this board with the conductor parts (19), leading laterally out from the plug socket (8) and the flat conductor (12).

4. Device according to one of the preceding Claims, characterized in that at least one of the conductor parts (19) projecting laterally from the conductor package (14) passes through the printed circuit board (16) and is contacted on a second printed circuit board (17), which is disposed parallel to and alongside the first printed circuit board (16).

5. Device according to one of the preceding Claims, characterized in that the conductor parts (19) themselves, leading out laterally from the conductor package (14), or a stud (24) formed on these conductor parts, are electrically connected with conductor paths (22) and/or with the conductor bridge (23) of the printed circuit board (16, 17, 18).

6. Device according to one of the preceding Claims, characterized in that, on the lateral printed circuit board (16, 17, 18), components such as resistor (25), capacitor (26), transistor (27), microprocessor (28) of the electronic controls for the different electrical consuming units of the automobile are disposed separately from the switching devices (10) which can be plugged into the plug sockets (8) and are connected, via the conductor paths (22), with the conductor parts (19) leading out laterally from the conductor package (14).

7. Device according to one of the preceding Claims, characterized in that the electronic controls for the various electrical consuming units of the automobile are brought centrally together in a microcomputer (29) on the printed circuit board (16, 17, 18) positioned on the side (15, 15') of the conductor package (14), which (microcomputer) comprises at least one microprocessor (28), constructed as an electronic computer, having at least one programme memory and at least one input and output unit and associated peripherals.

8. Device according to one of the preceding Claims, characterized in that, on the printed circuit board (17) provided laterally alongside the conductor package (14), generally in an extension of the laterally projecting conductor parts (19), contact plugs (30) for connection of cable bundles are disposed and are led out laterally.

9. Device according to one of the preceding Claims, characterized in that the printed circuit boards (16, 17, 18), connected with the plug sockets (8) and flat conductors (12) by the laterally leading-out conductor parts (19), are provided on two opposite, parallel sides (15, 15') of the conductor package (14).

10. Device according to one of the preceding Claims, characterized in that the conductor parts (19) of the flat conductors (12) and plug sockets (8), leading out laterally from the conductor package (14), are disposed on an electrically insulating support plate (21), which projects parallel to the plane of the flat conductors (12) at the side (15, 15') of the conductor package (14) and adjoins approximately perpendicularly the printed circuit board (18).

11. Device according to one of the preceding Claims, characterized in that the lateral printed circuit board (16, 17, 18) is disposed in the region of a projecting base part (36, 36') of a base plate (3) of a housing (2), extending beneath and common to the conductor package (14) and the printed circuit board (16, 17, 18), and is covered by a hood (4) of the housing (2) secured at the edges (38) of the base plate (3).

12. Device according to one of the preceding Claims, characterized in that the conductor parts (19) leading out from the plug sockets (8) and the flat conductors (12) pass through a lateral wall (20) of the housing (2) encasing the conductor package (14), that the printed circuit board (16, 17, 18) is provided externally adjacent to the wall (20) of the housing (2), and that a lateral hood (31, 31'), fitting over the printed circuit board (16, 17, 18) bears against the wall (20) of the housing (2).

13. Device according to one of the preceding Claims, characterized in that, at each of the opposite longitudinal sides (15, 15') of the housing (2), a lateral hood (31, 31') bearing against the walls (20) is provided.

14. Device according to one of the preceding Claims, characterized in that, in the lateral hood (31) covering the printed circuit board (16, 17), at least one recess (32, 32') for a multiple plug is formed, into which the contact plugs (30) of the printed circuit board (17) penetrate.

15. Device according to one of the preceding Claims, characterized in that the switching devices (10) and fuses (9) plugged into the plug sockets (8) on the top face (6) of the housing (2) are covered by a roof hood (33), which sits with a peripheral rim (34) on the housing (2) and preferably bears tightly against an edge part (35) of the lateral hood (31, 31').

16. Device according to one of the preceding Claims, characterized in that, where an electronic control for the electrical consuming units is disposed on the lateral printed circuit board (16, 17, 18), an electronic switch, preferably constructed as switching transistor, is provided in the plug-in switching device (10).

**Revendications**

1. Dispositif pour véhicule automobile, destiné au branchement centralisé de composants électriques tels que les fusibles (9), des fiches, des faisceaux de câbles, des commandes électroniques pour utilisateurs électriques, des dispositifs de commutation (10), avec un paquet de circuits imprimés (14), conçu sous une forme plate, comportant des conducteurs à plat (12) superposés dans des plans différents et qui sont séparés les uns des autres par des isolations intermédiaires (13) ainsi que des douilles de connexion (8) pour recevoir des fiches équipant les composants, dispositif caractérisé en ce qu'au moins à l'une des douilles (8) pour fiches, il est prévu au moins une pièce conductrice (19) dépassant au moins d'un côté (15, 15') le paquet de circuits imprimés (14), cette partie conductrice (19) étant susceptible d'être reliée au choix par un pont de contact (23) du côté (15, 15') du paquet de circuits imprimés (14), et à un autre conducteur plat (12) en saillie d'au moins un côté (15, 15') du paquet de circuits imprimés (14) et appartenant à au moins l'un des conducteurs plats (12) superposés, isolé.

2. Dispositif selon la revendication précédente, caractérisé en ce que d'un côté (15, 15') du paquet de circuits imprimés (14) appartenant à au moins une plaque de circuit imprimé (16, 17, 18) associée aux parties de conducteur (19) en saillie de la douille de connexion (8) et du conducteur plat (12), transversalement au plan du conducteur plat (12) et aux isolations intermédiaires (13).

3. Dispositif selon l'une des revendications précédentes, caractérisé en ce que le pont de contact (23) est prévu sur les plaques de circuit imprimé (16, 17, 18) et y est mis en contact avec les parties de conducteur (19) qui font saillie latéralement de la douille de connexion (8) et du conducteur plat (12).

4. Dispositif selon l'une des revendications précédentes, caractérisé en ce qu'au moins l'une des parties conductrices (19) latéralement en saillie du paquet de circuits imprimés (14) traverse la plaque de circuit imprimé (16) et est en contact avec une seconde plaque de circuit imprimé (17) qui est parallèle et à côté de la première plaque de circuit imprimé (16).

5. Dispositif selon l'une des revendications précédentes, caractérisé en ce que les parties de conducteur (19) qui sont latéralement en saillie par rapport au paquet de circuits imprimés (14) sont reliées aux chemins de contact (22) et/ou au pont de contact (23) des plaques de circuit imprimé (14, 17, 18) électriquement, directement ou par l'intermédiaire d'un téton (24) réalisé sur ces parties de conducteur.

6. Dispositif selon l'une des revendications précédentes, caractérisé en ce que des composants tels qu'une résistance (25), un condensateur (26), un transistor (27), un microprocesseur (28) des commandes électroniques des différents utilisateurs électriques du véhicule sont prévus sur les plaques de circuit imprimé (16, 17, 18) latérales, séparément des dispositifs de commutation (10) destinés à être enfichés dans les douilles de connexion (8) et ces composants sont reliés par les chemins conducteurs (22) aux parties de conducteur (19) latéralement en saillie par rapport au paquet de circuits imprimés (14).

7. Dispositif selon l'une des revendications précédentes, caractérisé en ce que les commandes électroniques des différents utilisateurs électriques du véhicule automobile sont réunies de manière centrale dans un microcalculateur (29) sur la plaque de circuit imprimé (16, 17, 18) placée sur le côté (15, 15') du paquet de plaques de circuit imprimé (14), cet ordinateur étant au moins un microprocesseur (28) conçu comme calculateur électronique, avec au moins une mémoire de programme ainsi qu'au moins une unité d'entrée et une unité de sortie ainsi que les dispositifs périphériques correspondants.

8. Dispositif selon l'une des revendications précédentes, caractérisé en ce que la plaque de circuit imprimé (17) prévue latéralement à côté du paquet de plaques de circuit imprimé (14) comporte des douilles de connexion (30) sensiblement dans le prolongement des parties de conducteur (19) latéralement en saillie, pour le branchement de faisceaux de câble en sortant latéralement.

9. Dispositif selon l'une des revendications précédentes, caractérisé en ce que les plaques de circuit imprimé (16, 17, 18) reliées aux douilles de connexion (8) et au conducteur plat (12) par les parties de conducteur (19) en saillie latéralement, sont prévues sur deux côtés parallèles (15, 15') opposés du paquet de plaques de circuit imprimé (14).

10. Dispositif selon l'une des revendications précédentes, caractérisé en ce que les parties de conducteur (19) des conducteurs plats (12) et des douilles de connexion (8), qui sont latéralement en saillie par rapport au paquet de plaques de circuit imprimé (14) sont montées sur une plaque de support (21) isolante électriquement, et qui est en saillie parallèlement au plan des conducteurs plats (12) sur un côté (15, 15') du paquet de conducteurs (14) en étant adjacente sensiblement à l'équerre par rapport à la plaque de circuit imprimé (18).

11. Dispositif selon l'une des revendications précédentes, caractérisé en ce que la plaque de circuit imprimé, latérale (16, 17, 18) est prévue dans la zone d'une partie de fond (36, 36') en saillie, appartenant à la plaque de fond (3) d'un boîtier (2) qui passe en-dessous du paquet de plaques de circuit imprimé (14) et de la plaque de circuit imprimé (16, 17, 18), prise en commun, et est recouvert par une coiffe (4) du boîtier (2) fixée au bord (38) de la plaque de fond (3).

12. Dispositif selon l'une des revendications précédentes, caractérisé en ce que les parties de conducteur (19) en saillie des douilles de connexion (8) et des conducteurs plats (12) traversent une paroi latérale (20) d'un boîtier (2) entourant le paquet de plaques de circuit imprimé (14), et la plaque de circuit imprimé (16, 17, 18) est prévue extérieurement à côté de la paroi (20) du boîtier (2) et en ce qu'un capot latéral (31, 31') passant pardessus la plaque de circuit imprimé (16, 17, 18) est appliqué contre la paroi (20) du boîtier (2).

13. Dispositif selon l'une des revendications précédentes, caractérisé en ce qu'au niveau des grands côtés opposés (15, 15') du boîtier (2), il est prévu chaque fois un capot latéral (31, 31') appliqué contre les parois (20).

14. Dispositif selon l'une des revendications précédentes, caractérisé en ce qu'au moins une découpe (32, 32') pour une fiche multiple est prévue dans le capot latéral (31) recouvrant la plaque de circuit imprimé (16, 17), cette découpe recevant les fiches de contact (30) de la plaque de circuit imprimé (17).

15. Dispositif selon l'une des revendications précédentes, caractérisé en ce que les appareils de commutation (10) enfichés dans les douilles de connexion (8) du côté supérieur (6) du boîtier (2) et les fusibles (9) sont recouverts par un capot supérieur (33) qui s'applique sur le boîtier (2) par son bord périphérique (34) et est de préférence limité directement contre une partie de bord (35) des capots latéraux (31, 31').

16. Dispositif selon l'une des revendications précédentes, caractérisé en ce que dans le cas d'une commande électronique pour utilisateur électrique prévue sur la plaque latérale de circuit imprimé (16, 17, 18) dans l'appareil de commutation (10) enfichable, il est prévu un commutateur électronique de préférence un transistor de commutation.

FIG. 1

FIG. 2